# EUROPÄISCHE PATENTSCHRIFT

(11) **EP 2 215 900 B1**
(45) Veröffentlichungstag und Bekanntmachung des Hinweises auf die Patenterteilung: **22.06.2011**
(21) Anmeldenummer: 08802844.4
(22) Anmeldetag: 09.10.2008
(51) Int. Cl.: H05K 1/16

(54) **FILTER IN EINEM MEHRLAGENSUBSTRAT MIT EINER ELEKTRISCHEN SCHALTUNGSANORDNUNG UMFASSEND KONZENTRIERTEN ELEMENTE**
FILTER IN A MULTI-LAYER SUBSTRATE WITH AN ELECTRICAL CIRCUIT ARRANGEMENT HAVING COMPACT ELEMENTS
FILTRE DANS UN SUBSTRAT MULTICOUCHES À CIRCUITERIE ÉLECTRIQUE À ÉLÉMENTS CONCENTRÉS

(30) Priorität: 05.12.2007 DE 102007058423; 15.01.2008 DE 102008004470
(43) Veröffentlichungstag der Anmeldung: 11.08.2010
(73) Patentinhaber: Rohde & Schwarz GmbH & Co. KG, 81671 München (DE)
(72) Erfinder: ZIEGLER, Robert, 83278 Traunstein (DE)
(74) Vertreter: Körfer, Thomas
(86) Internationale Anmeldenummer: PCT/EP2008/008535
(87) Internationale Veröffentlichungsnummer: WO 2009/071142

(56) Entgegenhaltungen:
- EP-A- 1 170 797
- EP-A- 1 596 478
- EP-A- 1 612 818
- EP-A- 1 737 283
- WO-A-2006/076607
- DE-A1- 1 590 704
- FR-A- 2 260 256
- GB-A- 2 040 591
- US-A1- 2003 063 427
- US-A1- 2003 107 869
- US-A1- 2003 141 942
- US-A1- 2006 092 594
- US-A1- 2007 222 031

## Beschreibung

Die Erfindung betrifft ein Filter, welches eine elektrische Schaltungsanordnung mit konzentrierten Elementen in Mehrlagensubstraten beinhaltet.

Herkömmlich werden Kapazitäten in Schaltungen als konzentrierte diskrete Bauelemente realisiert. So sind eine hohe Genauigkeit der Bauteiltoleranzen und ein vertretbarer Aufwand der Herstellung zu erreichen. Die resultierenden Kapazitäten nehmen jedoch in Schaltungen einen großen Raum ein und erfüllen die Bedingung der Symmetrie nicht immer optimal. Ein Ansatz zur Beseitigung dieser Schwierigkeiten ist die Nutzung integrierter Kapazitäten.

So zeigt die DE 195 40 570 A1 einen integrierten Kondensator in Fingerstruktur in einer Leiterplatte. Dabei werden zwei kammförmige Strukturen auf einer Lage ineinander verzahnt. Der so entstehende Kondensator ist jedoch in dem Wert seiner Kapazität beschränkt. Weiterhin benötigt er eine große Fläche.

Filterstrukturen mit diskreten Bauelementen werden herkömmlich auf Leiterplatten hergestellt. Dies erzeugt einen großen Platzbedarf. Weiterhin sind die Filter aufgrund des Aufbaus der Leiterplatte und der einzelnen Bauelemente nicht unbedingt ausreichend symmetrisch. Durch den Einsatz von keramischen Substraten und darauf integrierten Induktivitäten und Kapazitäten kann der Platzbedarf reduziert werden.

So zeigt die US 2005/0200431 A1 ein Filter auf einem keramischen Mehrlagensubstrat, welches Induktivitäten direkt als Leiterbahnen auf den Lagen des Substrats realisiert. So ist ein reduzierter Flächenbedarf gegenüber Leiterplatten möglich. Ein Ausgleich von Fertigungsprozessbedingten Toleranzen erfolgt jedoch nicht. Aufgrund der geringen Maße der auf den Ebenen des Mehrlagensubstrats aufgebrachten Leiterbahnen haben bereits geringe Verschiebungen der Substratlagen gegeneinander große Auswirkungen.

Die Veröffentlichung WO 2006/076607 A1, offenbart ein Verfahren zum Drucken von passiven elektrischen Komponenten. Dabei werden auf ein Substrat eine oder mehrere Lagen elektrisch leitfähiger und nicht elektrisch leitfhiger Materialien aufgebracht. Diese Veröffentlichung zeigt die Herstellung von Widerständen, Kapazitäten und Induktivitäten.

Das Dokument EP 1 612 818 A1, offenbart gedruckte Dickfilm-Kondensatoren und ein Verfahren zur Herstellung solcher. Dabei wird durch Auftragen mehrerer leitfähiger und nicht leitfähiger Schichten auf ein Substrat eine Kondensatorstruktur geschaffen. Durch Schichten mehrerer solcher Substratlagen werden mehrlagige Substrate erzeugt.

Das Dokument EP 1 737 283 A1, offenbart in eine Schaltung integrierte Kondensatoren und ein Verfahren zur Herstellung integrierter Kondensatoren. Es werden Kondensatorstrukturen durch Beschichten von Substraten mit leitfähigen und nicht leitfähigen Materialien erzeugt. Durch Kombination mehrerer Substrate und Schichten sind mehrlagige Substrate erreichbar.

Das Dokument US 2003/0107869 A1, offenbart einen Kondensator und ein Verfahren zur Herstellung eines Kondensators. Durch Aufbringen zumindest einer leitfähigen Schicht auf ein nicht leitfähiges Substrat wird eine Struktur mit kapazitiven Eigenschaften aufgebracht. Durch Übereinanderlagerung mehrerer solcher Strukturen werden mehrlagige Kondensatoren erzeugt.

Das Dokument US 2007/0222031 A1, offenbart eine Kondensatorstruktur. Durch Beschichtung eines nicht leitfähigen Substrats mit leitfähigen Flächen werden Kondensatoren erstellt.

Das Dokument GB 2 040 591 A, offenbart ein RC-Netzwerk. Das genannte RC-Netzwerk wird mittels leitfähiger Flächen, welche auf der Oberseite und der Unterseite eines nicht leitfähigen Substrats aufgebracht werden, erstellt.

Das Dokument DE 1 590 704, offenbart ein Verfahren zur Herstellung miniaturisierter Schaltungen und eine solcher Schaltungen. Dabei wird auf ein nicht leitfähiges Substrat eine Mehrzahl von leitfähigen und nicht leitfähigen Schichten aufgebracht, welche konzentrierte Bauelemente bilden. Dabei wird eine Serienschaltung aus einer Induktivität und einer Kapazität offenbart. Die Kapazität ist dabei durch zwei von einer nicht leitenden Schicht getrennten leitenden Schichten gebildet. Die obere leitfähige Schicht ist dabei in beiden Dimensionen kleiner als die darunterliegende leitfähige Schicht. Die in Serie geschaltete Induktivität ist dabei durch eine schleifenförmig verlaufende Leiterbahn gebildet.

Das Dokument US 2006/0092594 A1, offenbart eine integrierte Mehrlagenschaltung und ein Verfahren zur Herstellung dieser. Dabei werden auf eine nicht leitfähige Leiterplatte eine Mehrzahl von leitfähigen und nicht leitfähigen Schichten aufgebracht. Übereinanderliegende Flächen bilden dabei Kapazitäten. Schleifenförmig verlaufende Leiterbahnen bilden dabei Induktivitäten. Die resultierende Schaltung kann als Filter eingesetzt werden.

Das Dokument EP 1170 797 A2, offenbart einen Dünnfilm-Kondensator und eine Leiterplatte mit einem Dünnfilm-Kondensator. Der Dünnfilm Kondensator wird durch Aufbringen mehrerer Leitfähiger und nicht leitfähiger Schichten auf eine nicht leitfähige Leiterplatte gebildet. Übereinanderliegende leitfähige Schichten, welche durch eine nicht Leitfähige Schicht getrennt sind, bilden den Kondensator.

Das Dokument US 2003/0141942 A1, offenbart ein Verfahren und eine Vorrichtung zur dielektrischen Verlustkompensation. Dabei sind zwischen den Lagen einer mehrlagigen Leiterplatte leitende Strukturen integriert, welche Kapazitäten bilden.

Das Dokument EP 1 596 478 A2, offenbart einen Steckverbinder, welcher günstige Nebensprech-Eigenschaften aufweist. Teil des Steckverbinders ist dabei eine mehrlagige Leiterplatte, auf welcher mittels leitfähiger Flächen Filterstrukturen aufgebracht sind. So sind durch nebeneinander liegende Strukturen kapazitive Elemente und durch spiralförmige Strukturen induktive Elemente in die Leiterplatte integriert.

Die Druckschrift US 2003/0063427 A1, offenbart eine veränderliche Induktivität und eine veränderliche Kapazität. Diese werden durch mehrere leitfähige Lagen, jeweils getrennt durch nicht leitfähige Substratlagen, erzeugt. Es wird in diesem Dokument eine leitfähige Platte gezeigt, welche in beiden Dimensionen kleiner ist, als eine weitere leitfähige Platte und welche in beiden Dimensionen von der größeren Platte überlappt wird.

Das Dokument FR 2 260 256, offenbart elektrische Schaltungskomponenten, welche auf Mehrlagensubstraten realisiert werden. Dabei werden kapazitive und induktive Elemente durch leitfähige Flächen zwischen nicht leitfähigen Substratlagen realisiert. Dieses Dokument zeigt so Serienschaltungen von Induktivitäten und Kapazitäten und Parallelschaltungen von Induktivitäten und Kapazitäten.

Der Erfindung liegt die Aufgabe zu Grunde, Kapazitäten mit geringer Fertigungstoleranz als konzentrierte Bauelemente direkt auf einem Substrat zu schaffen. Weiterhin liegt die Aufgabe zu Grunde, einen Filter zu schaffen, welches ohne diskrete Bauelemente unter Ausnutzung konzentrierter Kapazitäten arbeitet.

Die Aufgabe wird erfindungsgemäß für die Schaltungsanordnung durch die Merkmale des Anspruchs 1 und für das Filter durch die Merkmale des Anspruchs 11 gelöst. Vorteilhafte Weiterbildungen sind Gegenstand der hierauf rückbezogenen Unteransprüche.

Das erfindungsgemäße Filter umfasst eine elelektrische Schaltungsanordnung, wobei die Schaltungsanordnung über ein Substrat und zumindest zwei leitfähige Flächen verfügt. Das Substrat besteht aus zumindest einer Lage. Zwischen den zumindest zwei leitfähigen Flächen befindet sich zumindest eine Lage des Substrats. Die zumindest zwei leitfähigen Flächen bilden eine Kapazität. Die leitfähigen Flächen überlappen zum Teil und bilden eine Überlappungsfläche. Die entstehende Überlappungsfläche ist bei Verschiebung der leitfähigen Flächen gegeneinander bis zu einem Grenzwert der Verschiebung weitgehend konstant. So ist eine konstante Kapazität auch bei herstellungstoleranzbasierter Verschiebung der leitfähigen Flächen gegeneinander gewährleistet.

Zumindest eine der leitfähigen Flächen ist in wenigstens einer Dimension kleiner als zumindest eine weitere der leitfähigen Flächen. Die zumindest eine in dieser Dimension kleinere leitfähige Fläche ist in dieser Dimension beidseitig von der zumindest einen in dieser Dimension größeren leitfähigen Fläche überlappt. So ist eine Verschiebung der leitfähigen Flächen gegeneinander in dieser einen Dimension ohne nennenswerte Veränderung der Kapazität möglich.

Das Filter beinhaltet zumindest eine erste Induktivität. Die erste Induktivität ist räumlich konzentriert. Damit ist die räumliche Ausdehnung der Induktivität wesentlich kleiner als die Wellenlängen der von dem Filter zu verarbeitenden Signale. Die konzentrierte Induktivität ist als leitfähiger Streifen auf dem Substrat realisiert. So ist der Filter in seinen Eigenschaften stabil gegen eine Verschiebung der Substratlagen gegeneinander. Weiterhin ist ein sehr platzsparender Aufbau des Filters durch den Einsatz von integrierten konzentrierten Kapazitäten möglich.

Das Filter ist weitgehend symmetrisch zu zumindest einer Achse aufgebaut. Die verbessert, insbesondere bei balancierten Signalen, die Hochfrequenzeigenschaften des Filters.

Die leitfähigen Flächen sind bevorzugt durch Metallisierung von zumindest den zwei Oberflächen zumindest einer Lage des Substrats gebildet. So können gängige Herstellungsprozesse eingesetzt werden. Weiterhin ist ein sicherer Halt der leitfähigen Flächen auf dem Substrat so gewährleistet.

Vorteilhafterweise ist zumindest eine der leitfähigen Flächen in beiden Dimensionen kleiner als zumindest eine weitere der leitfähigen Flächen. Vorteilhafterweise ist die zumindest eine kleinere leitfähige Fläche in beiden Dimensionen beidseitig von der zumindest einen größeren leitfähigen Fläche überlappt. So ist eine Verschiebung der leitfähigen Flächen gegeneinander in beiden Dimensionen ohne nennenswerte Veränderung der Kapazität möglich.

Das Substrat ist bevorzugt ein mehrlagiges Substrat. Die mehreren Lagen sind bevorzugt durch zumindest eine elektrisch leitfähige Durchkontaktierung verbunden. So kann die Schaltungsanordnung mit geringerem Bauvolumen hergestellt werden. Eine Nutzung tieferer Substratlagen ist mittels Durchkontaktierungen erleichtert möglich.

Die elektrische Schaltungsanordnung ist bevorzugt zumindest gegenüber einer Achse symmetrisch aufgebaut. Dies führt, insbesondere bei balancierten, insbesondere differentiellen Schaltungsanordnungen, zu einer Verbesserung des Hochfrequenzverhaltens. Weiterhin ist die Fertigung erleichtert.

Das Substrat ist bevorzugt ein keramisches Substrat oder eine dielektrische Leiterplatte. So ist ein Einsatz gängiger Herstellungsverfahren möglich.

Jeweils zumindest zwei leitfähige Flächen befinden sich bevorzugt auf zumindest zwei Seiten der zumindest einen Lage des Substrats. Jeder leitfähigen Fläche auf einer Seite der zumindest einen Lage des Substrats ist bevorzugt zumindest eine weitere leitfähige Fläche auf der anderen Seite der zumindest einen Lage des Substrats zugeordnet. Die einander zugeordneten leitfähigen Flächen überlappen bevorzugt zumindest zum Teil und bilden eine Überlappungsfläche. Die einander zugeordneten leitfähigen Flächen bilden Kapazitäten. Die zumindest zwei so gebildeten Kapazitäten sind bevorzugt parallel geschaltet.

Vorteilhafterweise liegt die erste leitfähige Fläche der ersten Kapazität und die erste leitfähige Fläche der zweiten Kapazität auf der ersten Seite der zumindest einen Lage des Substrats. Vorteilhafterweise liegt die zweite leitfähige Fläche der ersten Kapazität und die zweite leitfähige Fläche der zweiten Kapazität auf der zweiten Seite der zumindest einen Lage des Substrats. Die erste leitfähige Fläche der ersten Kapazität ist bevorzugt mit der zweiten leitfähigen Fläche der zweiten Kapazität verbunden. Die erste leitfähige Fläche der zweiten Kapazität ist bevorzugt mit der zweiten leitfähigen Fläche der ersten Kapazität verbunden. So ist durch die zweifache Ausführung der leitfähigen Flächen ein Ausgleich von fertigungstechnisch bedingten Flächentoleranzen möglich. Durch die antiparallele Verschaltung ist gewährleistet, dass die parasitären Kapazitäten gegenüber Äquipotentialflächen, z.B. Masseflächen, an beiden Anschlüssen gleich sind. Dies ist insbesondere für balancierte Strukturen wichtig.

Das Substrat weist bevorzugt zumindest zwei Lagen auf. Auf den Oberflächen des Substrats und zwischen zumindest zwei Lagen des Substrats befindet sich bevorzugt jeweils zumindest eine leitfähige Fläche. Zwischen den zwei leitfähigen Flächen befindet sich bevorzugt zumindest eine weitere leitfähige Fläche. Die weitere leitfähige Fläche ist bevorzugt nicht elektrisch mit den zumindest zwei Flächen verbunden. Die zwei leitfähigen Flächen und die eine weitere, nicht elektrisch mit den zwei leitfähigen Flächen verbundene, leitfähige Fläche bilden eine Kapazität. So kann die Kapazität bei gleichbleibendem Flächenbedarf weiter vergrößert werden.

Das Substrat weist bevorzugt mehrere Lagen auf. Die mehreren Lagen sind bevorzugt mittels leitfähigen Durchkontaktierungen verbunden. Das Filter erstreckt sich bevorzugt über mehrere Substratlagen. So kann der Platzbedarf des Filters weiter reduziert werden.

Vorteilhafterweise weist der leitfähige Streifen, welcher die zumindest eine Induktivität bildet, eine Krümmung auf und/oder ist bevorzugt spiralförmig und/oder schleifenförmig angeordnet. So kann die Induktivität des leitfähigen Streifens ohne Vergrößerung des Platzbedarfs erhöht werden.

Das Filter kann ein balanciertes Zweitor sein. Das Filter kann eine Allpass-Charakterisitik aufweisen. Das Filter erzeugt bevorzugt eine Phasenverzerrung (delay equalizer). Vorteilhafterweise besteht das Filter aus mehreren, mittels Kapazitäten parallel geschalteter Induktivitäten. So können phasenverzerrte Signale korrigiert werden. Vorteilhafterweise besteht das Filter aus zwei, mittels zweier Kapazitäten parallel geschalteter Induktivitäten. Die Induktivitäten sind bevorzugt überkreuzt angeordnet. Die Überkreuzung erfolgt bevorzugt mittels leitfähiger Durchkontaktierungen durch zumindest eine Lage des Substrats. Die Überkreuzung mittels einer Durchkontaktierung ist in der Herstellung sehr kostengünstig, da keine weiteren Prozessschritte notwendig sind. Bei einer alternativen Überkreuzung auf der Substratoberfläche durch z.B. Bonddrähte entsteht zusätzlicher Aufwand.

Das Filter verfügt bevorzugt über vier Anschlüsse. Die erste Induktivität ist bevorzugt mit dem ersten und vierten Anschluss verbunden. Die zweite Induktivität ist bevorzugt mit dem zweiten und dritten Anschluss verbunden. Die erste Kapazität ist bevorzugt mit dem ersten und zweiten Anschluss verbunden. Die zweite Kapazität ist bevorzugt mit dem dritten und vierten Anschluss verbunden. Das erste Tor des Filters ist bevorzugt dem ersten und dritten Anschluss parallel geschaltet. Das zweite Tor des Filters ist bevorzugt dem zweiten und vierten Anschluss parallel geschaltet. Die beiden Kapazitäten und Induktivitäten weisen bevorzugt jeweils weitgehend die gleiche Größe auf. Durch den weitgehend symmetrischen Aufbau werden die balancierten Hochfrequenzeigenschaften des Filters verbessert.

Das Filter ist vorteilhafterweise ein differentielles Zweitor und weist vorteilhafterweise eine Tiefpass-Charakteristik auf. So können hochfrequente Anteile eines Signals herausgefiltert werden.

Das Filter besteht bevorzugt aus mehreren mittels Induktivitäten parallel geschalteten Schaltungselementen, welche bevorzugt aus Serienschaltungen von Induktivitäten und Kapazitäten bestehen. Die Kapazitäten sind bevorzugt durch elektrische Schaltungsanordnungen nach Anspruch 1 bis 10 gebildet. So können Verschiebungen der Substratlagen gegeneinander ausgeglichen werden. Weiterhin ist der Platzbedarf eines solchen Filters sehr gering. Das Filter beinhaltet bevorzugt drei Schaltungselemente. Das erste Tor des Filters ist bevorzugt dem ersten Schaltungselement parallel geschaltet. Das zweite Schaltungselement ist bevorzugt dem ersten Schaltungselement mittels zweier Induktivitäten parallel geschaltet. Das dritte Schaltungselement ist bevorzugt dem zweiten Schaltungselement mittels zweier Induktivitäten parallel geschaltet. Das zweite Tor des Filters ist bevorzugt dem dritten Schaltungselement mittels zweier Induktivitäten parallel geschaltet. Die Schaltungselemente bestehen bevorzugt aus Serienschaltungen von jeweils einer ersten Induktivität, einer Kapazität und einer zweiten Induktivität. Die Kapazitäten des zweiten und dritten Schaltungselements sind bevorzugt größer als die Kapazität des ersten Schaltungselements. Die Induktivitäten des zweiten Schaltungselements sind bevorzugt größer, als die Induktivitäten des ersten und dritten Schaltungselements. Dieser Aufbau des Filters ermöglicht einen gleichmäßigen Frequenzgang bei gleichzeitig geringer Bauteilanzahl.

Vorteilhafterweise beinhaltet das Filter zumindest eine elektrische Schaltungsanordnung nach einem der Ansprüche 1 bis 5. Vorteilhafterweise beinhaltet das Filter weiterhin zumindest eine elektrische Schaltungsanordnung nach Anspruch 7. Vorteilhafterweise beinhaltet das Filter zumindest eine elektrische Schaltungsanordnung nach Anspruch 8. So ist der Platzbedarf des Filters durch die geringe Baugröße der elektrischen Schaltungsanordnungen weiter reduziert. Eine erhöhte Kapazität durch Einsatz der Schaltungsanordnungen nach Anspruch 7 oder 8 erweitert den Frequenzbereich des Filters.

Die Kapazität des ersten Schaltungselements ist bevorzugt durch eine elektrische Schaltungsanordnung nach Anspruch 8 gebildet. Die Kapazität des zweiten Schaltungselements ist bevorzugt durch eine elektrische Schaltungsanordnung nach einem der Ansprüche 1 bis 5 gebildet. Die Kapazität des dritten Schaltungselements ist bevorzugt durch eine elektrische Schaltungsanordnung nach Anspruch 7 gebildet. Eine hohe Kapazität des zweiten und dritten Schaltungselements wird so erreicht. Weiterhin kann so eine hohe Symmetrie des Aufbaus erreicht werden.

Nachfolgend wird die Erfindung anhand der Zeichnung, in der vorteilhafte Ausführungsbeispiele der Erfindung dargestellt sind, beispielhaft beschrieben. In der Zeichnung zeigen:
- Fig. 1: ein erstes Ausführungsbeispiel einer Schaltungsanordnung;
- Fig. 2: ein zweites Ausführungsbeispiel einer Schaltungsanordnung;
- Fig. 3: ein drittes Ausführungsbeispiel einer Schaltungsanordnung;
- Fig. 4a: eine Seitenansicht eines mehrlagigen Substrats mit metallisierten Flächen;
- Fig. 4b: ein Ersatzschaltbild des mehrlagigen Substrats aus Fig. 4a;
- Fig. 5: ein viertes Ausführungsbeispiel einer Schaltungsanordnung;
- Fig. 6: ein Ersatzschaltbild eines Ausführungsbeispiels eines Filters;
- Fig. 7: ein Ausführungsbeispiel eines Filters;
- Fig. 8: ein Ersatzschaltbild eines Ausführungsbeispiels des erfindungsgemäßen Filters, und
- Fig. 9: ein Ausführungsbeispiel des erfindungsgemäßen Filters.

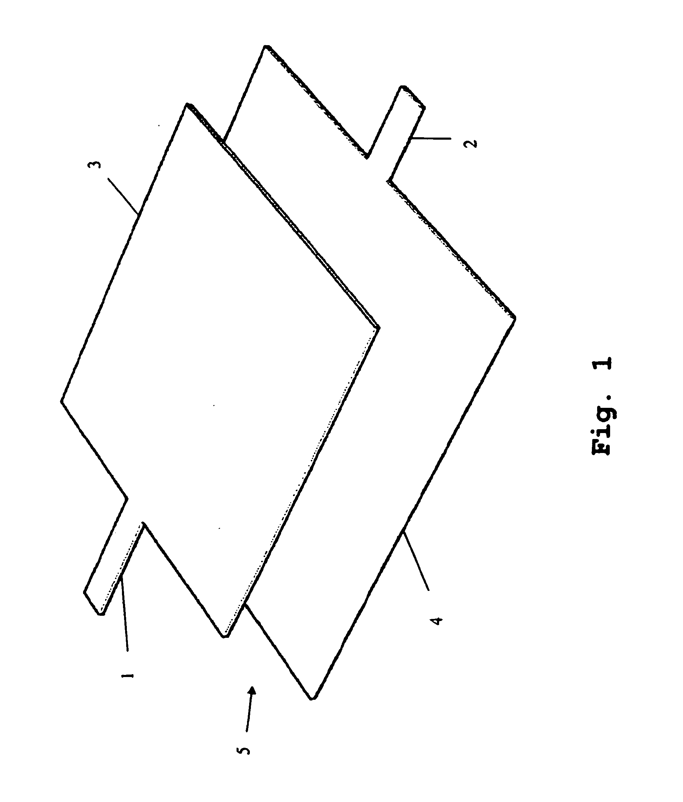

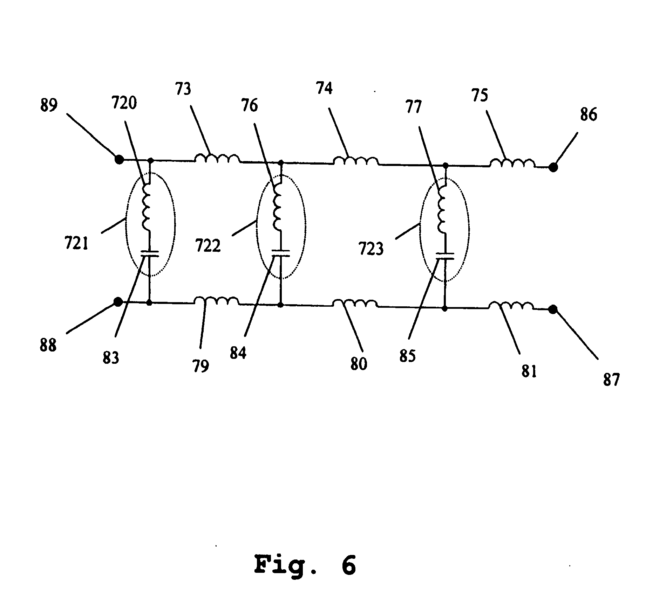

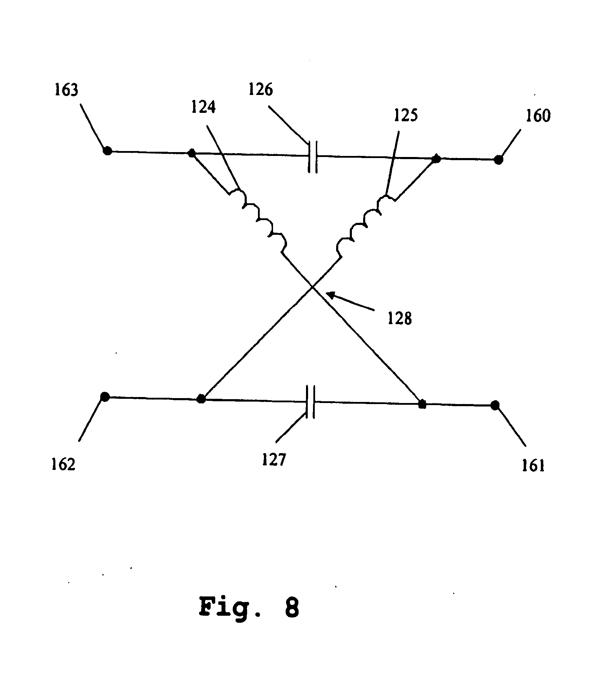

Zunächst wird anhand der Fig. 1 - 5 der Aufbau und die Funktionsweise verschiedener Ausführungsbeispiele einer Schaltungsanordnung gezeigt. Mittels Fig. 6 - 7 wird der Aufbau und die Funktionsweise eines Ausführungsbeispiels eines Filters erläutert. Mittels Fig. 8-9 wird der Aufbau und die Funktionsweise eines Ausführungsbeispiels des erfindungsgemäßen Filters erlaütert. Identische Elemente wurden in ähnlichen Abbildungen zum Teil nicht wiederholt dargestellt und beschrieben.

Fig. 1 zeigt ein erstes Ausführungsbeispiel einer Schaltungsanordnung. Auf den beiden Seiten eines Substrats 5 (hier als Zwischenraum dargestellt) befinden sich leitfähige Flächen 3 und 4. Diese werden über die Anschlüsse 1, 2 kontaktiert. Die leitfähige Fläche 3 ist dabei in beiden Dimensionen kleiner als die leitfähige Fläche 4. Sie wird in beiden Dimensionen von der leitfähigen Fläche 4 überragt. Damit ergibt sich eine Überlappungsfläche in der Größe der leitfähigen Fläche 3 und eines Teils des Anschlusses 1. Ist der Anschluss 1 wesentlich kleiner als die leitfähige Fläche 3, so kann er hinsichtlich der entstehenden Kapazität vernachlässigt werden. Die beiden leitfähigen Flächen 3, 4 bilden einen Plattenkondensator und damit eine Kapazität. Ergeben sich auf Grund von Fertigungstoleranzen Verschiebungen zwischen den leitfähigen Flächen 3, 4, so verändert sich die Kapazität zunächst nicht. Erst wenn der Rand der kleineren leitfähigen Fläche 3 den Rand der größeren leitfähigen Fläche 4 erreicht, beginnt eine Änderung der Kapazität, da die Überlappungsfläche sich nun ändert. Werden die Flächen der Anschlüsse berücksichtigt, ergibt sich möglicherweise bereits bei geringeren Verschiebungen eine geringfügige Änderung der Kapazität.

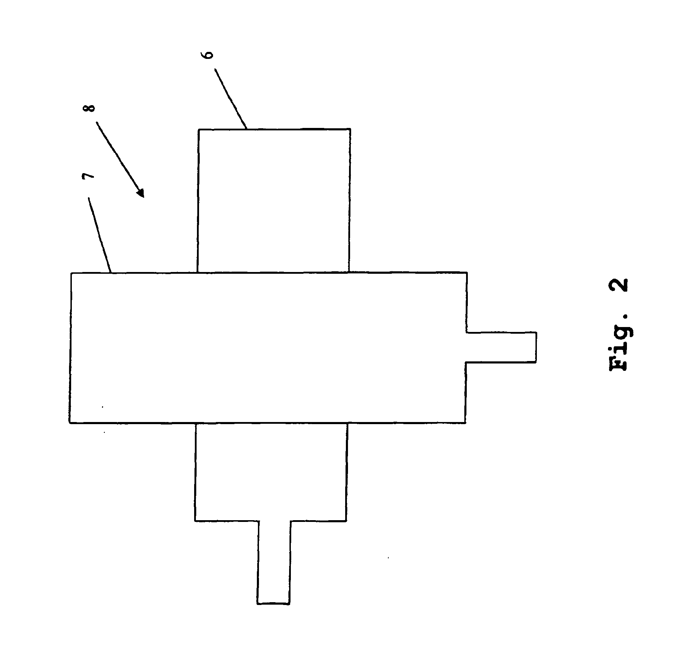

In Fig. 2 wird ein zweites Ausführungsbeispiel einer Schaltungsanordnung dargestellt. Die zwei leitfähigen Flächen 6, 7, welche auf den beiden Seiten eines Substrats 8 (hier transparent dargestellt) angebracht sind, bilden hier ebenfalls eine Überlappungsfläche. Beide leitfähigen Flächen haben eine ähnliche Größe. Sie sind dabei jeweils in einer Dimension deutlich weiter ausgedehnt als in der anderen. Die beiden Flächen bilden so eine kreuzförmige Struktur. Der Kreuzungsbereich bildet die Überlappungsfläche. Diese Form der Vorrichtung weist einen noch wesentlich größeren Verschiebebereich auf, in welchen sich die Kapazität nicht nennenswert ändert, als die in Fig. 1 gezeigte Struktur. Allerdings ist ein größerer Platzbedarf ebenfalls die Folge.

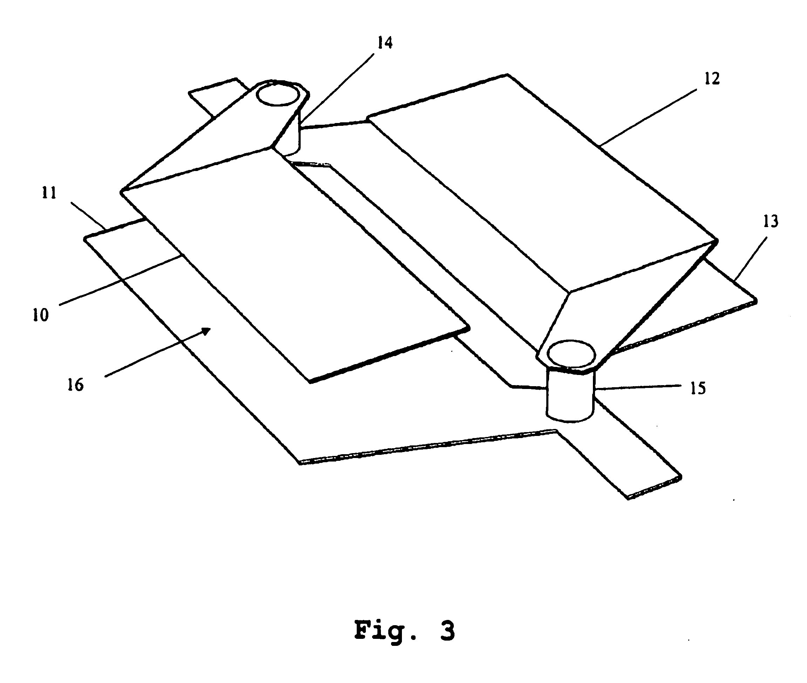

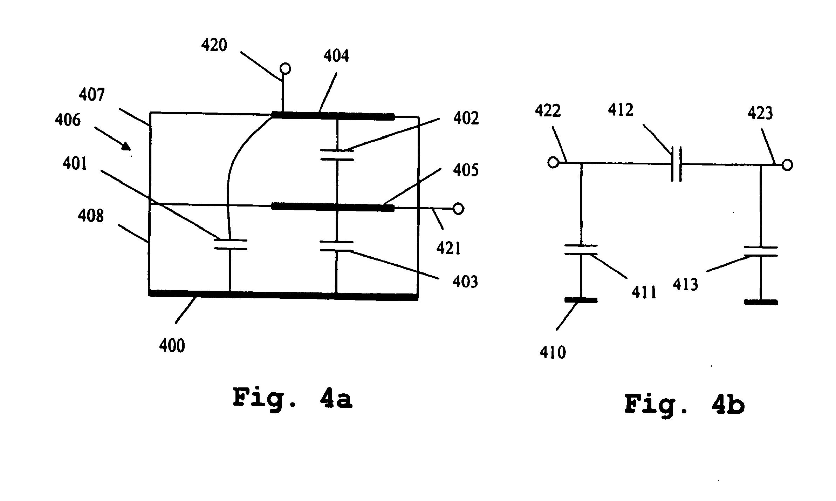

Fig. 3 zeigt ein drittes Ausführungsbeispiel einer Schaltungsanordnung. Auf den beiden Oberflächen eines Substrats 16 (hier als Zwischenraum dargestellt) befinden sich jeweils zwei leitfähige Flächen 10, 11, 12, 13. Die vier leitfähigen Flächen 10, 11, 12, 13 bilden zwei Strukturen, wie in Fig. 1 gezeigt. Dabei bilden die sich gegenüberstehenden leitfähigen Flächen 10 und 11, 12 und 13 jeweils eine solche Struktur und damit jeweils eine Kapazität. Die Kapazitäten sind parallel geschaltet. Dies erfolgt durch Verbindung von jeweils zwei der leitfähigen Flächen miteinander. So sind die leitfähigen Flächen 11 und 12, 10 und 13 miteinander leitend verbunden. Die Verbindung erfolgt dabei mittels leitfähiger Durchkontaktierungen 14, 15 durch das Substrat 16. Die beiden leitfähigen Flächen 10, 12 auf der einen Seite des Substrats 16 sind kleiner als die leitfähigen Flächen 11, 13 auf der anderen Seite des Substrats 16. Wie bereits anhand der Fig. 1 dargestellt, ist die Uberlappungsfläche so auch bei Verschiebung bis zu einer gewissen Größe der Verschiebung konstant. Damit ist auch die Kapazität der beiden parallel geschalteten Kondensatoren konstant. Parasitäre Kapazitäten gegenüber einer Masseebene sind an beiden Anschlüssen gleich, da die unterschiedlichen parasitären Kapazitäten der jeweiligen leitfähigen Flächen identisch sind. Dieser Effekt ist anhand der Fig. 4a und 4b näher erläutert.

In Fig. 4a wird eine Seitenansicht eines mehrlagigen Substrats 406 mit metallisierten Flächen 400, 404, 405 gezeigt. Auf der Oberfläche des Substrats 406 liegt die erste metallisierte Fläche 404. Zwischen den beiden Schichten 407, 408 des Substrats 406 liegt die zweite metallisierte Fläche 405. Die Unterseite des Substrats 406 ist vollständig metallisiert und weist Massepotential auf. Die beiden metallisierten Flächen bilden die erstrebte Kapazität 402 zwischen den Anschlüssen 420, 421. Zusätzlich bilden sie jeweils gegenüber der metallisierten Substratunterseite 400 eine parasitäre Kapazitäten 401, 403. Da die beiden metallisierten Flächen auf unterschiedlichen Substratlagen liegen und sich zum Teil gegenseitig abschirmen weisen die beiden parasitären Kapazitäten unterschiedliche Werte auf. Dies ist der Symmetrie der Schaltungsanordnung abträglich und eignet sich daher nur bedingt für balancierte Schaltungen.

Fig. 4b zeigt ein Ersatzschaltbild des mehrlagigen Substrats aus Fig. 4a. Zwischen den beiden Anschlüssen 422, 423 ist die erstrebte Kapazität 412 geschaltet. An jeden Anschluss 422, 423 ist eine parasitäre Kapazität 411, 413 gegenüber Massepotential angeschlossen. Bei dem in Fig. 4a dargestellten mehrlagigen Substrat weisen die beiden parasitären Kapazitäten unterschiedliche Werte auf. Die antiparallele Verschaltung, wie in Fig. 3 dargestellt kompensiert die Unsymmetrie. Im Ersatzschaltbild ergeben sich weitgehend gleiche Werte für die beiden parasitären Kapazitäten.

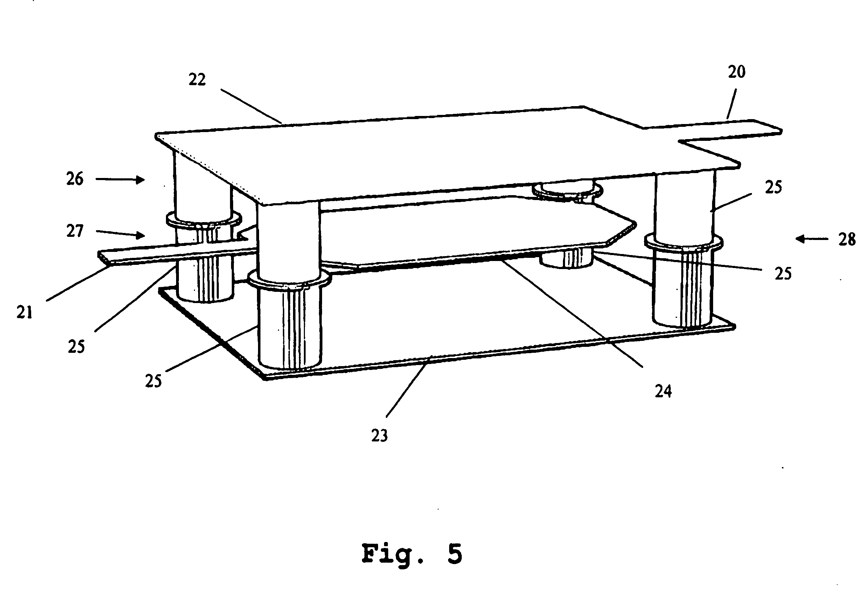

In Fig. 5 wird ein viertes Ausführungsbeispiel einer Schaltungsanordnung dargestellt. Das Substrat 28 (hier als Zwischenräume dargestellt) ist hier zweilagig ausgeführt. Auf den beiden äußeren Oberflächen des Substrats 28 ist jeweils eine leitfähige Fläche 22, 23 aufgebracht. Zwischen den beiden Lagen 26, 27 des Substrats 28 befindet sich eine weitere leitfähige Fläche 24. Die beiden äußeren leitfähigen Flächen 22, 23 sind mittels der leitfähigen Durchkontaktierungen durch beide Lagen 26, 27 des Substrats 28 miteinander verbunden und über den Anschluss 20 kontaktiert. Die zwischen den Lagen 26, 27 des Substrats 28 befindliche leitfähige Fläche 24 ist mittels des Anschlusses 21 kontaktiert. Die leitfähigen Flächen 22, 23, 24 bilden einen Plattenkondensator. Da die innere leitfähige Fläche 24 in beiden Dimensionen kleiner ist als die beiden äußeren leitfähigen Flächen 22, 23 ist auch hier der Effekt der konstanten Überlappungsfläche und damit der konstanten Kapazität bei Verschiebung der leitfähigen Flächen gegeneinander gegeben.

Fig. 6 zeigt ein Ersatzschaltbild eines Ausführungsbeispiels eines Filters. Es handelt sich um ein balanciertes (differentielles) Zweitorfilter mit Tiefpass-Charakteristik. Die Anschlüsse 88, 89 bilden das erste Tor des Filters. Die Anschlüsse 86, 87 bilden das zweite Tor des Filters. Das Filter besteht aus der Parallelschaltung von drei Schaltungselementen mittels Induktivitäten 73, 74, 75, 79, 80, 81. Die Schaltungselemente bestehen dabei jeweils aus einer Induktivität 720, 76, 77 und einer Kapazität 83, 84, 85. Das erste Schaltungselement ist direkt mit dem ersten Tor des Filters verbunden. Es besteht aus der Induktivität 720 und der Kapazität 83. Das zweite Schaltungselement ist dem ersten Schaltungselement mittels der Induktivitäten 73, 79 parallel geschaltet. Es besteht aus der Induktivität 76 und der Kapazität 84. Das dritte Schaltungselement ist dem zweiten Schaltungselement mittels der Induktivitäten 74, 80 parallel geschaltet. Es besteht aus der Induktivität 77 und der Kapazität 85. Das zweite Tor des Filters ist dem dritten Schaltungselement mittels der Induktivitäten 75, 81 parallel geschaltet.

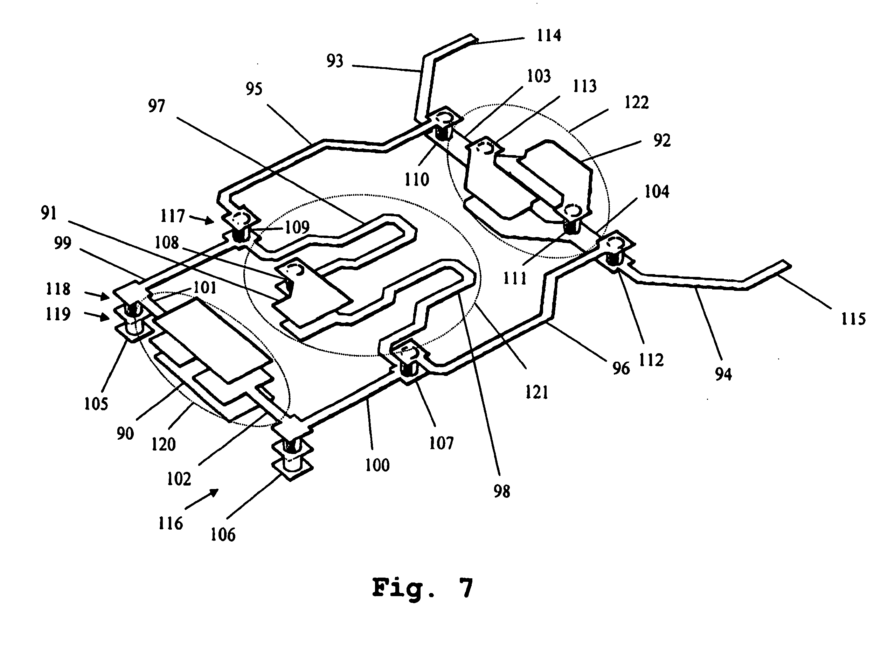

In Fig. 7 wird eine Realisierung des Ausführungsbeispiels des Filters nach Fig. 6 dargestellt. Das Filter ist als dreidimensionales Schaubild der realen Bauelemente dargestellt. Die Substratlagen sind dabei als Zwischenräume zwischen den metallisierten Lagen dargestellt. Das hier gezeigte Filter entspricht dem Ersatzschaltbild aus Fig. 6. Die Durchkontaktierungen 105, 106 bilden das erste Tor des Filters. Die Enden der Streifenleiter 114, 115 bilden das zweite Tor des Filters. Zwischen den beiden Durchkontaktierungen 105, 106, welche das erste Tor des Filters bilden, ist eine Kapazität 90, ähnlich der in Fig. 5 dargestellten Kapazität, mittels der beiden Streifenleiter 101, 102 angeschlossen. Im Gegensatz zu der Kapazität aus Fig. 5 ist die Kapazität 90 lediglich an den beiden Seiten der geteilten mittleren Fläche angeschlossen. Durchkontaktierungen sind nicht vorhanden. Die leitfähigen Flächen über und unter dem Spalt erhöhen dabei die Kapazität. Die Streifenleiter 101, 102 bilden dabei jeweils eine kleine Induktivität. Die Induktivitäten des Ersatzschaltbilds sind dabei stets geteilt aufgebaut, um die Symmetrie aufrecht zu erhalten.

Die Kapazität 90 und die beiden Induktivitäten entsprechen dabei dem ersten Schaltungselement 83 aus Fig. 6. Mittels der weiteren Streifenleitungen 99, 100, welche ebenfalls Induktivitäten bilden, ist eine zweite Serienschaltung von einer Kapazität 91 und Induktivitäten, welche durch die schleifenförmigen Streifenleitungen 97, 98 gebildet sind, und ein zweites Schaltungselement 121 bilden, parallel zu dem ersten Schaltungselement 120 geschaltet. Die Kapazität 91 entspricht einer Kapazität, wie sie in Fig. 1 dargestellt ist. Die Durchkontaktierung 108 ist zum Wechseln der Substratlage notwendig. Diese Struktur entspricht dem zweiten Schaltungselement aus Fig. 6.

Mittels der Durchkontaktierungen 107, 109 ist eine weitere Serienschaltung aus einer Kapazität 92 und Induktivitäten, gebildet durch die Streifenleitungen 103, 104, welche ein drittes Schaltungselement 122 bilden, mittels zweier Induktivitäten dem zweiten Schaltungselement 121 parallel geschaltet. Diese Induktivitäten werden dabei von den kurvenförmig verlaufenden Streifenleitern 95, 96 gebildet. Die Kapazität 92 ist dabei als Struktur, wie in Fig. 3 gezeigt, ausgebildet und über die Durchkontaktierungen 111, 113 mit den kurzen Streifenleitern 103, 104, welche Induktivitäten bilden, verbunden. Über die Streifenleiter 93, 94, welche ebenfalls Induktivitäten bilden, ist das zweite Tor des Filters angeschlossen.

Fig. 8 zeigt ein Ersatzschaltbild eines Ausführungsbeispiels des erfindungsgemäßen Filters. Auch das hier gezeigt Filter ist ein balanciertes (differentielles) Zweitorfilter. Die Anschlüsse 162 und 163 bilden das erste Tor des Filters. Die Anschlüsse 160 und 161 bilden das zweite Tor des Filters. Bei dem Filter handelt es sich um einen Allpass-Filter. Dies ist ein Filter, welcher sämtliche Frequenzanteile weitgehend identisch stark gedämpft überträgt. Gleichzeitig wird jedoch eine frequenzabhängige Gruppenlaufzeit (τ = -dϕ/dω) verursacht. Dies dient dem Ausgleich einer Phasenverzerrung des Eingangssignals. Die beiden Tore des Filters sind jeweils mit zwei Kapazitäten 126, 127 verbunden. Dabei sind die Anschlüsse 163 und 160 durch die Kapazität 126 verbunden. Die Anschlüsse 162 und 161 sind durch die Kapazität 127 verbunden. Weiterhin sind die Tore durch die Induktivitäten 124, 125 verbunden. So sind die Anschlüsse 163 und 161 mittels der Induktivität 124 verbunden. Die Anschlüsse 160 und 162 sind mittels der Induktivität 125 verbunden. Die Induktivitäten überkreuzen sich ohne leitende Verbindung im Kreuzungspunkt 128.

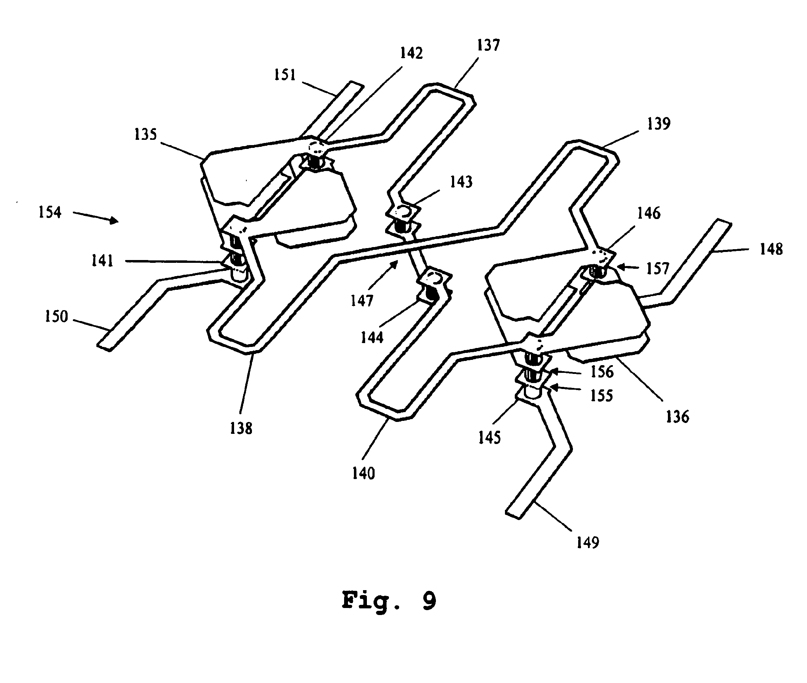

In Fig. 9 wird eine Realisierung des Ausführungsbeispiels des erfindungsgemäßen Filters gemäß Fig. 8 dargestellt. Das Filter ist als dreidimensionales Schaubild der realen Bauelemente dargestellt. Die Substratlagen sind dabei als Zwischenräume zwischen den metallisierten Lagen dargestellt. Das hier gezeigte Filter entspricht dem Ersatzschaltbild aus Fig. 8. Die Streifenleiter 149, 150 bilden das erste Tor des Filters. Die Streifenleiter 148, 151 bilden das zweite Tor des Filters. Mittels der Durchkontaktierungen 141, 142 sind die beiden Streifenleiter 150, 151 durch die Kapazität 135 verbunden.

Die Kapazität 135 entspricht einer Struktur, wie in Fig. 3 gezeigt. Mittels der Durchkontaktierungen 145, 146 sind die beiden Streifenleiter 149, 148 durch die Kapazität 136 verbunden. Die Kapazität 136 entspricht einer Struktur, wie in Fig. 3 gezeigt. Weiterhin sind die beiden Streifenleiter 150, 148 mittels der Durchkontaktierungen 141, 146 durch die Streifenleiter 138, 139, welche Induktivitäten bilden, verbunden. Die beiden Streifenleiter 151, 149 sind mittels der Durchkontaktierungen 142, 145 durch die Streifenleiter 137, 140, welche Induktivitäten bilden, verbunden. Die Streifenleiter 137, 138, 139, 140 sind dabei schleifenförmige ausgebildet. Die Streifenleiter 138, 139 und 137, 140 überkreuzen sich dabei in einem Kreuzungspunkt 147. Die Überkreuzung ist mittels der Durchkontaktierungen 143, 144 realisiert. So ist eine Überkreuzung ohne leitende Verbindung möglich. Die Streifenleiter 137, 138, 139, 140 weisen dabei weitgehend dieselbe Größe auf. Die Kapazitäten 135, 136 weisen dabei ebenfalls weitgehend dieselbe Größe auf. Der Filter ist weitgehend symmetrisch aufgebaut. Durch die Symmetrie verfügt der Filter über sehr gute Hochfrequenzeigenschaften.

Die Erfindung ist nicht auf das dargestellte Ausführungsbeispiel beschränkt. Wie bereits erwähnt, können Substrate unterschiedlicher Lagenanzahl zur Bildung der Kapazitäten genutzt werden. Verschiedene Substratmaterialien sind dabei ebenfalls einsetzbar. Insbesondere ein Einsatz von Materialien mit sehr hohem ε_{R} denkbar um die Kapazitäten weiter zu vergrößern. Ebenso sind Filter unterschiedlicher Übertragungsfunktionen und unterschiedlichen Phasenverhaltens denkbar. Alle vorstehend beschriebenen Merkmale oder in den Figuren gezeigten Merkmale sind im Rahmen der Erfindung vorteilhaft miteinander kombinierbar.

## Patentansprüche

1. Filter mit zumindest einer elektrischen Schaltungsanordnung,
wobei die Schaltungsanordnung ein Substrat (5, 8, 16, 28) und zumindest zwei leitfähige Flächen (3, 4, 6, 7, 10, 11, 12, 13, 21, 22, 23) aufweist,
wobei das Substrat (5, 8, 16, 28) aus zumindest einer Lage besteht,
wobei sich zwischen den zumindest zwei leitfähigen Flächen (3, 4, 6, 7, 10, 11, 12, 13, 21, 22, 23) zumindest eine Lage des Substrats (5, 8, 16, 28) befindet,
wobei die zumindest zwei leitfähigen Flächen (3, 4, 6, 7, 10, 11, 12, 13, 21, 22, 23) eine Kapazität bilden,
wobei die leitfähigen Flächen (3, 4, 6, 7, 10, 11, 12, 13, 21, 22, 23) zumindest zum Teil überlappen und eine Überlappungsfläche bilden,
wobei die entstehende Überlappungsfläche bei Verschiebung der leitfähigen Flächen (3, 4, 6, 7, 10, 11, 12, 13, 21, 22, 23) gegeneinander bis zu einem Grenzwert der Verschiebung weitgehend konstant ist,
wobei zumindest eine der leitfähigen Flächen (3, 6, 7, 10, 12, 21) in wenigstens einer Dimension kleiner ist, als zumindest eine weitere der leitfähigen Flächen (4, 6, 7, 11, 13, 22, 23),
wobei die zumindest eine in dieser Dimension kleinere leitfähige Fläche (3, 6, 7, 10, 12, 21) in dieser Dimension beidseitig von der zumindest einen in dieser Dimension größeren leitfähigen Fläche (4, 6, 7, 11, 13, 22, 23) überlappt ist,
wobei das Filter zumindest eine erste Induktivität (73, 74, 75, 76, 77, 79, 80, 81, 93, 94, 95, 96, 97, 98, 99, 100, 101, 102, 124, 125, 137, 138, 139, 140, 720) beinhaltet,
wobei die erste Induktivität (73, 74, 75, 76, 77, 79, 80, 81, 93, 94, 95, 96, 97, 98, 99, 100, 101, 102, 124, 125, 137, 138, 139, 140, 720) konzentriert ist,
wobei die konzentrierte Induktivität als leitfähiger Streifen auf dem Substrat (116, 154) realisiert ist, und wobei das Filter weitgehend symmetrisch zu zumindest einer Achse aufgebaut ist.

2. Filter nach Anspruch 1,
**dadurch gekennzeichnet**,
wobei die leitfähigen Flächen (3, 4, 6, 7, 10, 11, 12, 13, 21, 22, 23) durch Metallisierung von zumindest den zwei Oberflächen zumindest einer Lage des Substrats (5, 8, 16, 28) gebildet sind.

3. Filter nach Anspruch 1 oder 2,
**dadurch gekennzeichnet,**
**dass** zumindest eine der leitfähigen Flächen (3, 10, 12, 21) in beiden Dimensionen kleiner ist als zumindest eine weitere der leitfähigen Flächen (4, 11, 13, 22, 23) und dass die zumindest eine kleinere leitfähige Fläche (3, 10, 12, 21) in beiden Dimensionen beidseitig von der zumindest einen größeren leitfähigen Fläche (4, 11, 13, 22, 23) überlappt ist.

4. Filter nach einem der Ansprüche 1 bis 3,
**dadurch gekennzeichnet,**
**dass** das Substrat (5, 8, 16, 28) ein mehrlagiges Substrat (28) ist und
**dass** die mehreren Lagen (26, 27) des Substrats (28) durch zumindest eine elektrisch leitfähige Durchkontaktierung (25) verbunden sind.

5. Filter nach einem der Ansprüche 1 bis 4,
**dadurch gekennzeichnet,**
**dass** das Substrat (5, 8, 16, 28) ein keramisches Substrat oder eine dielektrische Leiterplatte ist.

6. Filter nach einem der Ansprüche 1 bis 5,
**dadurch gekennzeichnet,**
**dass** sich jeweils zumindest zwei leitfähige Flächen (10, 11, 12, 13) auf zumindest zwei Seiten der zumindest einen Lage des Substrats (16) befinden,
**dass** jeder leitfähigen Fläche (10, 12) auf einer Seite der zumindest einen Lage des Substrats (16) zumindest eine weitere leitfähige Fläche (11, 13) auf der anderen Seite der zumindest einen Lage des Substrats (16) zugeordnet ist,
**dass** die einander zugeordneten leitfähigen Flächen (10, 11 und 12, 13) zumindest zum Teil überlappen und eine Überlappungsfläche bilden,
**dass** die einander zugeordneten leitfähigen Flächen (10, 11 und 12, 13) Kapazitäten bilden und
**dass** die zumindest zwei so gebildeten Kapazitäten parallel geschaltet sind.

7. Filter nach Anspruch 6,
**dadurch gekennzeichnet,**
**dass** die erste leitfähige Fläche (10) der ersten Kapazität und die erste leitfähige Fläche (12) der zweiten Kapazität auf der ersten Seite der zumindest einen Lage des Substrats (16) liegt,
**dass** die zweite leitfähige Fläche (11) der ersten Kapazität und die zweite leitfähige Fläche (13) der zweiten Kapazität auf der zweiten Seite der zumindest einen Lage des Substrats (16) liegt,
**dass** die erste leitfähige Fläche (10) der ersten Kapazität mit der zweiten leitfähigen Fläche (13) der zweiten Kapazität verbunden ist und
**dass** die erste leitfähige Fläche (12) der zweiten Kapazität mit der zweiten leitfähigen Fläche (11) der ersten Kapazität verbunden ist.

8. Filter nach einem der Ansprüche 1 bis 6,
**dadurch gekennzeichnet,**
**dass** das Substrat (28) zumindest zwei Lagen (26, 27) aufweist,
**dass** sich auf den Oberflächen des Substrats (28) und zwischen zumindest zwei Lagen (26, 27) des Substrats (28) jeweils zumindest eine leitfähige Fläche (21, 22, 23) befindet,
**dass** sich zwischen den zwei leitfähigen Flächen (22, 23) zumindest eine weitere leitfähige Fläche (21) befindet, dass die weitere leitfähige Fläche (21) nicht elektrisch mit den zumindest zwei Flächen (22, 23) verbunden ist, und dass die zwei leitfähigen Flächen (22, 23) und die eine weitere, nicht elektrisch mit den zwei leitfähigen Flächen (22, 23) verbundene, leitfähige Fläche (21) eine Kapazität bilden.

9. Filter nach einem der Ansprüche 1 bis 8,
**dadurch gekennzeichnet,**
**dass** das Substrat (116, 154) mehrere Lagen (117, 118, 119, 155, 156, 157) aufweist,
**dass** die mehreren Lagen (117, 118, 119, 155, 156, 157) mittels leitfähigen Durchkontaktierungen verbunden sind und
**dass** sich das Filter über mehrere Substratlagen (117, 118, 119, 155, 156, 157) erstreckt.

10. Filter nach einem der Ansprüche 1 bis 9,
**dadurch gekennzeichnet,**
**dass** der leitfähigen Streifen, welcher die zumindest eine Induktivität (73, 74, 75, 76, 77, 79, 80, 81, 93, 94, 95, 96, 97, 98, 99, 100, 101, 102, 124, 125, 137, 138, 139, 140, 720) bildet, eine Krümmung aufweist und/oder schleifenförmig und/oder spiralförmig angeordnet ist.

11. Filter nach einem der Ansprüche 1 bis 10,
**dadurch gekennzeichnet,**
**dass** das Filter ein differentielles Zweitor ist,
**dass** das Filter eine Allpass-Charakterisitk aufweist und dass das Filter eine Phasenverzerrung erzeugt (delay equalizer).

12. Filter nach Anspruch 11,
**dadurch gekennzeichnet,**
**dass** das Filter aus mehreren, mittels Kapazitäten (126, 127, 135, 136) parallel geschalteter Induktivitäten (124, 125, 137, 138, 139, 140) besteht.

13. Filter nach Anspruch 11 oder 12,
**dadurch gekennzeichnet,**
**dass** das Filter aus zwei, mittels zweier Kapazitäten (126, 127, 135, 136) parallel geschalteter Induktivitäten (124, 125, 137, 138, 139, 140) besteht,
**dass** die Induktivitäten (124, 125, 137, 138, 139, 140) überkreuzt angeordnet sind und
**dass** die Überkreuzung (128, 147) mittels leitfähiger Durchkontaktierungen durch zumindest eine Lage (157) des Substrats (154) erfolgt.

14. Filter nach Anspruch 13,
**dadurch gekennzeichnet,**
**dass** das Filter über vier Anschlüsse (160, 161, 162, 163, 148, 149, 150, 151) verfügt,
**dass** die erste Induktivität (124, 138 und 139) mit einem ersten Anschluss (163, 150) und einem vierten Anschluss (161, 148) verbunden ist,
**dass** die zweite Induktivität (125, 137 und 140) mit einem zweiten Anschluss (160, 151) und einem dritten Anschluss (162, 149) verbunden ist und
**dass** die erste Kapazität (126, 135) mit dem ersten Anschluss (163, 150) und zweiten Anschluss (160, 151) verbunden ist,
**dass** die zweite Kapazität (127, 136) mit dem dritten Anschluss (162, 149) und vierten Anschluss (161, 148) verbunden ist.

15. Filter nach Anspruch 14,
**dadurch gekennzeichnet,**
**dass** ein erstes Tor des Filters dem ersten Anschluss (163, 150) und dem dritten Anschluss (162, 149) parallel geschaltet ist,
**dass** ein zweites Tor des Filters dem zweiten Anschluss (160, 151) und dem vierten Anschluss (161, 148) parallel geschaltet ist, und
**dass** die beiden Kapazitäten (126, 127, 135, 136) und Induktivitäten (124, 125, 138 und 139, 140 und 137) paarweise jeweils weitgehend die gleiche Größe aufweisen.

16. Filter nach einem der Ansprüche 9 oder 10,
**dadurch gekennzeichnet**
**dass** das Filter ein differentielles Zweitor ist und dass das Filter eine Tiefpass-Charakteristik aufweist.

17. Filter nach Anspruch 16,
**dadurch gekennzeichnet,**
**dass** das Filter aus mehreren mittels Induktivitäten (73, 74, 79, 80, 95, 96, 99, 100) parallel geschalteten Schaltungselementen (120, 121, 122, 721, 722, 723) besteht,
**dass** die Schaltungselemente (120, 121, 122, 721, 722, 723) aus Serienschaltungen von Induktivitäten (76, 77, 720, 97, 98, 101, 102, 103, 104) und Kapazitäten (83, 84, 85, 90, 91, 92) bestehen und
**dass** die Kapazitäten (83, 84, 85) durch elektrische Schaltungsanordnungen nach Anspruch 1 bis 10 gebildet sind.

18. Filter nach Anspruch 17,
**dadurch gekennzeichnet,**
**dass** das Filter drei Schaltungselemente (120, 121, 122, 721, 722, 723) beinhaltet,
**dass** ein erstes Tor des Filters dem ersten Schaltungselement (120, 721) parallel geschaltet ist, dass das zweite Schaltungselement (121, 722) dem ersten Schaltungselement (120, 721) mittels zweier Induktivitäten (73, 79, 99, 100) parallel geschaltet ist,
**dass** das dritte Schaltungselement (122, 723) dem zweiten Schaltungselement (121, 722) mittels zweier Induktivitäten (74, 80, 95, 96) parallel geschaltet ist,
**dass** ein zweites Tor des Filters dem dritten Schaltungselement (122, 723) mittels zweier Induktivitäten (75, 81, 93, 94) parallel geschaltet ist,
**dass** die Schaltungselemente (120, 121, 122, 721, 722, 723) aus Serienschaltungen von jeweils einer ersten Induktivität (97, 101, 103), einer Kapazität (83, 84, 85, 90, 91, 92) und einer zweiten Induktivität (98, 102, 104) bestehen.

19. Filter nach Anspruch 18,
**dadurch gekennzeichnet,**
**dass** die Kapazität (83, 90) des ersten Schaltungselements (120, 721) kleiner ist als die Kapazitäten (84, 85, 91, 92) des zweiten und dritten Schaltungselements (121, 122, 722, 723) und
**dass** die Induktivitäten (97, 98) des zweiten Schaltungselements (121, 722) größer sind, als die Induktivitäten (101, 102, 103, 104) des ersten und dritten Schaltungselements (120, 122, 721, 723).

20. Filter nach einem der Ansprüche 16 bis 19,
**dadurch gekennzeichnet,**
**dass** das Filter zumindest eine elektrische Schaltungsanordnung nach einem der Ansprüche 1 bis 5 beinhaltet,
**dass** der Filter zumindest eine elektrische Schaltungsanordnung nach Anspruch 7 beinhaltet, und dass der Filter zumindest eine elektrische Schaltungsanordnung nach Anspruch 8 beinhaltet.

21. Filter nach Anspruch 19 oder 20,
**dadurch gekennzeichnet,**
**dass** die Kapazität des ersten Schaltungselements durch eine elektrische Schaltungsanordnung nach Anspruch 8 gebildet ist,
**dass** die Kapazität des zweiten Schaltungselements durch eine elektrische Schaltungsanordnung nach einem der Ansprüche 1 bis 5 gebildet ist und
**dass** die Kapazität des dritten Schaltungselements durch eine elektrische Schaltungsanordnung nach Anspruch 7 gebildet ist.

## Claims

1. Filter having at least one electrical circuit arrangement,
the circuit arrangement having a substrate (5, 8, 16, 28) and at least two conductive areas (3, 4, 6, 7, 10, 11, 12, 13, 21, 22, 23),
the substrate (5, 8, 16, 28) consisting of at least one layer,
at least one layer of the substrate (5, 8, 16, 28) being situated between the at least two conductive areas (3, 4, 6, 7, 10, 11, 12, 13, 21, 22, 23),
the at least two conductive areas (3, 4, 6, 7, 10, 11, 12, 13, 21, 22, 23) forming a capacitance,
the conductive areas (3, 4, 6, 7, 10, 11, 12, 13, 21, 22, 23) at least partially overlapping and forming an overlapping area,
the overlapping area produced being largely constant, when displacing the conductive areas (3, 4, 6, 7, 10, 11, 12, 13, 21, 22, 23) with respect to one another, up to a displacement limit value,
at least one of the conductive areas (3, 6, 7, 10, 12, 21) being smaller in at least one dimension than at least one other area of the conductive areas (4, 6, 7, 11, 13, 22, 23),
the at least one conductive area (3, 6, 7, 10, 12, 21) which is smaller in this dimension being overlapped on both sides in this dimension by the at least one conductive area (4, 6, 7, 11, 13, 22, 23) which is larger in this dimension,
the filter comprising at least one first inductance (73, 74, 75, 76, 77, 79, 80, 81, 93, 94, 95, 96, 97, 98, 99, 100, 101, 102, 124, 125, 137, 138, 139, 140, 720),
the first inductance (73, 74, 75, 76, 77, 79, 80, 81, 93, 94, 95, 96, 97, 98, 99, 100, 101, 102, 124, 125, 137, 138, 139, 140, 720) being concentrated,
the concentrated inductance being in the form of a conductive strip on the substrate (116, 154), and
the filter being constructed in a largely symmetrical manner with respect to at least one axis.

2. Filter according to Claim 1,
**characterized**
**in that** the conductive areas (3, 4, 6, 7, 10, 11, 12, 13, 21, 22, 23) are formed by metallizing at least the two surfaces of at least one layer of the substrate (5, 8, 16, 28).

3. Filter according to Claim 1 or 2,
**characterized**
**in that** at least one of the conductive areas (3, 10, 12, 21) is smaller in both dimensions than at least one other area of the conductive areas (4, 11, 13, 22, 23), and
**in that** the at least one smaller conductive area (3, 10, 12, 21) is overlapped on both sides in both dimensions by the at least one larger conductive area (4, 11, 13, 22, 23).

4. Filter according to one of Claims 1 to 3, **characterized**
**in that** the substrate (5, 8, 16, 28) is a multilayer substrate (28), and
**in that** the plurality of layers (26, 27) of the substrate (28) are connected by means of at least one electrically conductive plated-through hole (25).

5. Filter according to one of Claims 1 to 4, **characterized**
**in that** the substrate (5, 8, 16, 28) is a ceramic substrate or a dielectric printed circuit board.

6. Filter according to one of Claims 1 to 5, **characterized**
**in that** at least two conductive areas (10, 11, 12, 13) are respectively situated on at least two sides of the at least one layer of the substrate (16),
**in that** each conductive area (10, 12) on one side of the at least one layer of the substrate (16) is associated with at least one further conductive area (11, 13) on the other side of the at least one layer of the substrate (16),
**in that** the conductive areas (10, 11 and 12, 13) which are associated with one another at least partially overlap and form an overlapping area,
**in that** the conductive areas (10, 11 and 12, 13) which are associated with one another form capacitances, and in that the at least two capacitances formed in this manner are connected in parallel.

7. Filter according to Claim 6,
**characterized**
**in that** the first conductive area (10) of the first capacitance and the first conductive area (12) of the second capacitance lie on the first side of the at least one layer of the substrate (16),
**in that** the second conductive area (11) of the first capacitance and the second conductive area (13) of the second capacitance lie on the second side of the at least one layer of the substrate (16),
**in that** the first conductive area (10) of the first capacitance is connected to the second conductive area (13) of the second capacitance, and
**in that** the first conductive area (12) of the second capacitance is connected to the second conductive area (11) of the first capacitance.

8. Filter according to one of Claims 1 to 6,
**characterized**
**in that** the substrate (28) has at least two layers (26, 27),
**in that** at least one conductive area (21, 22, 23) is respectively situated on the surfaces of the substrate (28) and between at least two layers (26, 27) of the substrate (28),
**in that** at least one further conductive area (21) is situated between the two conductive areas (22, 23),
**in that** the further conductive area (21) is not electrically connected to the at least two areas (22, 23), and
**in that** the two conductive areas (22, 23) and the one further conductive area (21) which is not electrically connected to the two conductive areas (22, 23) form a capacitance.

9. Filter according to one of Claims 1 to 8,
**characterized**
**in that** the substrate (116, 154) has a plurality of layers (117, 118, 119, 155, 156, 157),
**in that** the plurality of layers (117, 118, 119, 155, 156, 157) are connected using conductive plated-through holes, and
**in that** the filter extends over a plurality of substrate layers (117, 118, 119, 155, 156, 157).

10. Filter according to one of Claims 1 to 9,
**characterized**
**in that** the conductive strip which forms the at least one inductance (73, 74, 75, 76, 77, 79, 80, 81, 93, 94, 95, 96, 97, 98, 99, 100, 101, 102, 124, 125, 137, 138, 139, 140, 720) has a curvature and/or is arranged in the form of a loop and/or a spiral.

11. Filter according to one of Claims 1 to 10,
**characterized**
**in that** the filter is a differential two-port network,
**in that** the filter has an all-pass characteristic, and in that the filter generates a phase distortion (delay equalizer).

12. Filter according to Claim 11,
**characterized**
**in that** the filter consists of a plurality of inductances (124, 125, 137, 138, 139, 140) which are connected in parallel using capacitances (126, 127, 135, 136).

13. Filter according to Claim 11 or 12,
**characterized**
**in that** the filter consists of two inductances (124, 125, 137, 138, 139, 140) which are connected in parallel using two capacitances (126, 127, 135, 136),
**in that** the inductances (124, 125, 137, 138, 139, 140) are arranged in a cross-over manner, and
**in that** the crossover (128, 147) is effected using conductive plated-through holes through at least one layer (157) of the substrate (154).

14. Filter according to Claim 13,
**characterized**
**in that** the filter has four connections (160, 161, 162, 163, 148, 149, 150, 151),
**in that** the first inductance (124, 138 and 139) is connected to a first connection (163, 150) and to a fourth connection (161, 148),
**in that** the second inductance (125, 137 and 140) is connected to a second connection (160, 151) and to a third connection (162, 149),
**in that** the first capacitance (126, 135) is connected to the first connection (163, 150) and to the second connection (160, 151), and
**in that** the second capacitance (127, 136) is connected to the third connection (162, 149) and to the fourth connection (161, 148).

15. Filter according to Claim 14,
**characterized**
**in that** a first port of the filter is connected in parallel with the first connection (163, 150) and with the third connection (162, 149),
**in that** a second port of the filter is connected in parallel with the second connection (160, 151) and with the fourth connection (161, 148), and
**in that** the two capacitances (126, 127, 135, 136) and inductances (124, 125, 138 and 139, 140 and 137) each have largely the same size in pairs.

16. Filter according to either of Claims 9 and 10,
**characterized**
**in that** the filter is a differential two-port network, and
**in that** the filter has a low-pass characteristic.

17. Filter according to Claim 16,
**characterized**
**in that** the filter consists of a plurality of circuit elements (120, 121, 122, 721, 722, 723) which are connected in parallel using inductances (73, 74, 79, 80, 95, 96, 99, 100),
**in that** the circuit elements (120, 121, 122, 721, 722, 723) consist of series circuits comprising inductances (76, 77, 720, 97, 98, 101, 102, 103, 104) and capacitances (83, 84, 85, 90, 91, 92), and
**in that** the capacitances (83, 84, 85) are formed by electrical circuit arrangements according to Claims 1 to 10.

18. Filter according to Claim 17,
**characterized**
**in that** the filter comprises three circuit elements (120, 121, 122, 721, 722, 723),
**in that** a first port of the filter is connected in parallel with the first circuit element (120, 721),
**in that** the second circuit element (121, 722) is connected in parallel with the first circuit element (120, 721) using two inductances (73, 79, 99, 100),
**in that** the third circuit element (122, 723) is connected in parallel with the second circuit element (121, 722) using two inductances (74, 80, 95, 96),
**in that** a second port of the filter is connected in parallel with the third circuit element (122, 723) using two inductances (75, 81, 93, 94),
**in that** the circuit elements (120, 121, 122, 721, 722, 723) consist of series circuits each comprising a first inductance (97, 101, 103), a capacitance (83, 84, 85, 90, 91, 92) and a second inductance (98, 102, 104).

19. Filter according to Claim 18,
**characterized**
**in that** the capacitance (83, 90) of the first circuit element (120, 721) is smaller than the capacitances (84, 85, 91, 92) of the second and third circuit elements (121, 122, 722, 723), and
**in that** the inductances (97, 98) of the second circuit element (121, 722) are larger than the inductances (101, 102, 103, 104) of the first and third circuit elements (120, 122, 721, 723).

20. Filter according to one of Claims 16 to 19,
**characterized**
**in that** the filter comprises at least one electrical circuit arrangement according to one of Claims 1 to 5, in that the filter comprises at least one electrical circuit arrangement according to Claim 7, and
**in that** the filter comprises at least one electrical circuit arrangement according to Claim 8.

21. Filter according to Claim 19 or 20,
**characterized**
**in that** the capacitance of the first circuit element is formed by an electrical circuit arrangement according to Claim 8,
**in that** the capacitance of the second circuit element is formed by an electrical circuit arrangement according to one of Claims 1 to 5, and
**in that** the capacitance of the third circuit element is formed by an electrical circuit arrangement according to Claim 7.

## Revendications

1. Filtre comportant au moins un agencement de circuit électrique,
dans lequel l'agencement de circuit présente un substrat (5, 8, 16, 28) et au moins deux surfaces conductrices (3, 4, 6, 7, 10, 11, 12, 13, 21, 22, 23),
dans lequel le substrat (5, 8, 16, 28) est constitué d'au moins une couche,
dans lequel au moins une couche de substrat (5, 8, 16, 28) se trouve entre les au moins deux surfaces conductrices (3, 4, 6, 7, 10, 11, 12, 13, 21, 22, 23),
dans lequel les au moins deux surfaces conductrices (3, 4, 6, 7, 10, 11, 12, 13, 21, 22, 23) forment une capacité,
dans lequel les surfaces conductrices (3, 4, 6, 7, 10, 11, 12, 13, 21, 23) se recouvrent au moins partiellement et forment une surface de recouvrement,
dans lequel la surface de recouvrement est sensiblement constante lors du déplacement des surfaces conductrices (3, 4, 6, 7, 10, 11, 12, 13, 21, 22, 23) l'une contre l'autre jusqu'à une valeur limite du déplacement,
dans lequel au moins une des surfaces conductrices (3, 6, 7, 10, 12, 21) présente au moins une dimension plus petite qu'au moins une autre des surfaces conductrices (4, 6, 7, 11, 13, 22, 23),
dans lequel la au moins une surface conductrice plus petite dans cette dimension (3, 6, 7, 10, 12, 21) est recouverte dans cette dimension des deux côtés par au moins l'une des surfaces conductrices plus grandes dans cette dimension (4, 6, 7, 11, 13, 22, 23),
dans lequel le filtre comprend au moins une première inductivité (73, 74, 75, 76, 77, 79, 80, 81, 93, 94, 95, 96, 97, 98, 99, 100, 101, 102, 124, 125, 137, 138, 139, 140, 720),
dans lequel la première inductivité (73, 74, 75, 76, 77, 79, 80, 81, 93, 94, 95, 96, 97, 98, 99, 100, 101, 102, 124, 125, 137, 138, 139, 140, 720) est concentrée,
dans lequel l'inductivité concentrée est réalisée sous la forme d'une bande conductrice sur le substrat (116, 154), et
dans lequel le filtre est réalisé sensiblement symétriquement à au moins un axe.

2. Filtre selon la revendication 1, **caractérisé en ce que**,
les surfaces conductrices (3, 4, 6, 7, 10, 11, 12, 13, 21, 22, 23) sont formés par métallisation d'au moins deux surfaces d'au moins une couche du substrat (5, 8, 16, 28).

3. Filtre selon la revendication 1 ou 2, **caractérisé en ce que**
au moins une des surfaces conductrices (3, 10, 12, 21) est plus petite dans les deux dimensions qu'au moins une autre des surfaces conductrices (4, 11, 13, 22, 23) et
**en ce que** la au moins une surface conductrice plus petite (3, 10, 12, 21) est recouverte dans les deux dimensions des deux côtés par la au moins une surface conductrice plus grande (4, 11, 13, 22, 23).

4. Filtre selon l'une des revendications 1 à 3, **caractérisé en ce que**
le substrat (5, 8, 16, 28) est un substrat multicouches (28) et
**en ce que** les couches multiples (26, 27) du substrat (28) sont reliées par au moins un contact traversant électriquement conducteur (25).

5. Filtre selon l'une des revendications 1 à 4, **caractérisé en ce que**
le substrat (5, 8, 16, 28) est un substrat céramique ou une carte diélectrique de circuits imprimés.

6. Filtre selon l'une des revendications 1 à 5, **caractérisé en ce que**
au moins deux surfaces conductrices (10, 11, 12, 13) se trouvent respectivement sur au moins deux côtés de la au moins une surface du substrat (16),
**en ce que**, à chaque surface conductrice (10, 12) sur un côté de la au moins une surface du substrat (16) est associée au moins une autre surface conductrice (11, 13) sur l'autre côté de la au moins une couche du substrat (16),
**en ce que** les surfaces conductrices associées à une autre (10, 11 et 12, 13) se recouvrent au moins partiellement et forment une surface de recouvrement,
**en ce que** les surfaces conductrices associées à une autre (10, 11 et 12, 13) forment des capacités et
**en ce que** les au moins deux capacités ainsi formées sont montées en parallèle.

7. Filtre selon la revendication 6, **caractérisé en ce que**
la première surface conductrice (10) de la première capacité et la première surface conductrice (12) de la seconde capacité se trouvent sur le premier côté de la au moins une couche du substrat (16),
**en ce que** la seconde surface conductrice (11) de la première capacité et la seconde surface conductrice (13) de la seconde capacité se trouvent sur le second côté de la au moins une couche du substrat (16),
**en ce que** la première surface conductrice (10) de la première capacité est reliée à la seconde surface conductrice (13) de la seconde capacité et
**en ce que** la première surface conductrice (12) de la seconde capacité est reliée à la seconde surface conductrice (11) de la première capacité.

8. Filtre selon l'une des revendications 1 à 6, **caractérisé en ce que**
le substrat (28) présente au moins deux couches (26, 27),
**en ce qu'**au moins une surface conductrice (21, 22, 23) se trouve respectivement sur la surface du substrat (28) et entre au moins deux couches (26, 27) du substrat (28),
**en ce qu'**au moins une autre surface conductrice (21) se trouve entre les deux surfaces conductrices (22, 23),
**en ce que** l'autre surface conductrice (21) n'est pas reliée électriquement aux au moins deux surfaces (22, 23), et
**en ce que** les deux surfaces conductrices (22, 23) et l'autre surface conductrice (21) non reliée électriquement aux deux surfaces conductrices (22, 23) forment une capacité.

9. Filtre selon l'une des revendications 1 à 8, **caractérisé en ce que**
le substrat (116, 154) présente plusieurs couches (117, 118, 119, 155, 156, 157),
**en ce que** la pluralité de couches (117, 118, 119, 155, 156, 157) sont reliées par l'intermédiaire de contacts traversants conducteurs et
**en ce que** le filtre s'étend sur plusieurs couches du substrat (117, 118, 119, 155, 156, 157).

10. Filtre selon l'une des revendications 1 à 9, **caractérisé en ce que**
la bande conductrice, qui forme la au moins une inductivité (73, 74, 75, 76, 77, 79, 80, 81, 93, 94, 95, 96, 97, 98, 99, 100, 101, 102, 124, 125, 137, 138, 139, 140, 720) présente une courbure et/ou est disposée en forme de boucle et/ou en forme de spirale.

11. Filtre selon l'une des revendications 1 à 10, **caractérisé en ce que**
le filtre est un biporte différentiel,
le filtre présente une caractéristique de passe-tout et
le filtre génère une distorsion de phase (delay equalizer).

12. Filtre selon la revendication 11, **caractérisé en ce que**
le filtre est constitué de plusieurs inductivités reliées en parallèle (124, 125, 137, 138, 139, 140) grâce à des capacités (126, 127, 135, 136).

13. Filtre selon la revendication 11 ou 12, **caractérisé en ce que**
le filtre est constitué par deux inductivités (124, 125, 137, 138, 139, 140) reliées en parallèle grâce à des secondes capacités (126, 127, 135, 136),
**en ce que** les inductivités (124, 125, 137, 138, 139, 140) sont disposées en croix et
**en ce que** la transition (128, 147) est effectuée grâce à des contacts traversants conducteurs à travers au moins une couche (157) du substrat (154).

14. Filtre selon la revendication 13, **caractérisé en ce que**
le filtre dispose de quatre connexions (160, 161, 162, 163, 148, 149, 150, 151),
**en ce que** la première inductivité (124, 138 et 139) est reliée à une première connexion (163, 150) et à une quatrième connexion (161, 148),
**en ce que** la seconde inductivité (125, 137 et 140) est reliée à une seconde connexion (160, 151) et à une troisième connexion (162, 149) et
**en ce que** la première capacité (126, 135) est reliée à la première connexion (163, 150) et à la seconde connexion (160, 151),
**en ce que** la seconde capacité (127, 136) est reliée à la troisième connexion (162, 149) et à la quatrième connexion (161, 148).

15. Filtre selon la revendication 14, **caractérisé en ce que**
une première porte du filtre est reliée en parallèle à la première connexion (163, 150) et à la troisième connexion (162, 149),
en se qu'une seconde porte du filtre est reliée en parallèle à la seconde connexion (160, 151) et à la quatrième connexion (161, 148), et
**en ce que** les deux capacités (126, 127, 135, 136) et les inductivités (124, 125, 138 et 139, 140 et 137) présentent deux par deux respectivement sensiblement la même taille.

16. Filtre selon l'une des revendications 9 ou 10, **caractérisé en ce que**
le filtre est un biporte différentiel et
**en ce que** le filtre présente une caractéristique de passe-bas.

17. Filtre selon la revendication 16, **caractérisé en ce**
le filtre est constitué de plusieurs éléments de circuit (120, 121, 122, 721, 722, 723) montés en parallèle grâce à des inductivités (73, 74, 79, 80, 95, 96, 99, 100),
en ce que les éléments de circuit (120, 121, 122, 721, 722, 723) sont constitués de circuits série d'inductivités (76, 77, 720, 97, 98, 101, 102, 103, 104) et de capacités (83, 84, 85, 90, 91, 92) et
en ce que les capacités (83, 84, 85) sont formées par des agencements de circuits électriques selon les revendications 1 à 10.

18. Filtre selon la revendication 17, **caractérisé en ce que**
le filtre comprend trois éléments de circuit (120, 121, 122, 721, 722, 723),
la première porte du filtre est reliée en parallèle au premier élément de circuit (120, 721),
le second élément de circuit (121, 722) est relié en parallèle au premier élément de circuit (120, 721) grâce aux deux inductivités (73, 79, 99, 100),
**en ce que** le troisième élément de circuit (122, 723) est relié en parallèle au second élément de circuit (121, 722) grâce aux deux inductivités (74, 80, 95, 96),
en qu'une seconde porte du filtre est reliée en parallèle au troisième élément de circuit (122, 723) grâce aux deux inductivités (75, 81, 93, 94),
**en ce que** les éléments de circuit (120, 121, 122, 721, 722, 723) sont constitués de circuits série constitués respectivement d'une première inductivité (97, 101, 103), d'une capacité (83, 84, 85, 90, 91, 92) et d'une seconde inductivité (98, 102, 104).

19. Filtre selon la revendication 18, **caractérisé en ce que**
la capacité (83, 90) du premier élément de circuit (120, 721) est plus petite que les capacités (84, 85, 91, 92) des second et troisième éléments de circuit (121, 122, 722, 723) et
**en ce que** les inductivités (97, 98) du second élément de circuit (121, 722) sont plus grandes que les inductivités (101, 102, 103, 104) des premier et troisième éléments de circuit (120, 122, 721, 723).

20. Filtre selon l'une des revendications 16 à 19, **caractérisé en ce que**
le filtre comprend au moins un agencement de circuit selon l'une des revendications 1 à 5,
**en ce que** le filtre comprend au moins un agencement de circuit électrique selon la revendication 7,
et
**en ce que** le filtre comprend au moins un agencement de circuit électrique selon la revendication 8.

21. Filtre selon la revendication 19 ou 20, **caractérisé en ce que**
la capacité du premier élément de circuit est formée par un agencement de circuit électrique selon la revendication 8,
**en ce que** la capacité du second élément de circuit est formée par un agencement de circuit électrique selon l'une des revendications 1 à 5 et
**en ce que** la capacité du troisième élément de circuit est formée par un agencement de circuit électrique selon la revendication 7.
